Europäisches Patentamt

European Patent Office

Office européen des brevets

(19)

(11) **EP 1 226 443 B1**

(12) ## FASCICULE DE BREVET EUROPEEN

(45) Date de publication et mention
de la délivrance du brevet:
**10.09.2003 Bulletin 2003/37**

(21) Numéro de dépôt: **00974581.1**

(22) Date de dépôt: **27.10.2000**

(51) Int Cl.7: **G01R 21/02**, G01R 22/04

(86) Numéro de dépôt international:
**PCT/FR00/02999**

(87) Numéro de publication internationale:
**WO 01/031349 (03.05.2001 Gazette 2001/18)**

(54) **CAPTEUR D'ONDES ELECTROMAGNETIQUES**

SENSOR FÜR ELEKTROMAGNETISCHE WELLEN

ELECTROMAGNETIC WAVE SENSOR

(84) Etats contractants désignés:
**AT BE CH CY DE DK ES FI FR GB GR IE IT LI LU
MC NL PT SE**

(30) Priorité: **28.10.1999 FR 9913541**

(43) Date de publication de la demande:
**31.07.2002 Bulletin 2002/31**

(73) Titulaire: **CENTRE NATIONAL DE
LA RECHERCHE SCIENTIFIQUE (CNRS)
75794 Paris Cedex 16 (FR)**

(72) Inventeurs:
• **DAULLE, Armelle
F-38000 Grenoble (FR)**
• **RICHARD, Jacques
F-38000 Grenoble (FR)**

• **XAVIER, Pascal
F-38700 Corenc (FR)**
• **RAULY, Dominique
F-38000 Grenoble (FR)**

(74) Mandataire: **Le Forestier, Eric et al
Cabinet Régimbeau
20, rue de Chazelles
75847 Paris cedex 17 (FR)**

(56) Documents cités:
**US-A- 4 789 823     US-A- 5 302 024**

• **PATENT ABSTRACTS OF JAPAN vol. 015, no.
139 (E-1053), 9 avril 1991 (1991-04-09) & JP 03
019290 A (SANYO ELECTRIC CO LTD), 28 janvier
1991 (1991-01-28)**

**Description**

L'invention concerne le domaine des capteurs pour la mesure directe de la puissance électromagnétique, ainsi que leur fabrication.

La mesure de la puissance d'une onde électromagnétique est très utile dans de nombreux domaines industriels.

La connaissance des niveaux de puissance à tous les étages est cruciale pour les performances de la plupart des équipements des micro-ondes, que ce soit pendant la phase de conception de ces équipements ou lors de leur utilisation normale. Chaque composant doit recevoir le niveau de puissance adéquate du composant en amont et doit lui-même fournir le bon niveau au composant en aval. Si le niveau de puissance est trop bas, le signal utile est noyé dans le bruit. Si le niveau est trop haut, on se heurte à des problèmes de distorsion et de saturation. D'autre part, aux fréquences micro-ondes, la puissance est une caractéristique bien définie pour les métrologues, contrairement à la tension ou au courant.

La mesure de la puissance d'une onde électromagnétique est généralement effectuée à l'aide de capteurs de puissance électromagnétique isolés ou de wattmètres radiofréquence (RF) et hyperfréquence (HF) comprenant de tels capteurs.

On connaît déjà des capteurs de puissance électromagnétique utilisant pour la mesure de celle-ci, des diodes ou des capteurs thermiques, tels que des bolomètres ou des thermocouples.

Le document US 5 302 024 (publié le 12 avril 1994) cite dans son préambule des techniques de mesure classiques utilisant des fils de Wallaston, des thermistors ou des thermocouples.

Dans les capteurs à diode, la diode est montée dans une cellule de détection et la tension moyenne à la sortie de cette cellule permet de mesurer la puissance en amont de la diode. Les avantages de tels capteurs de puissance sont, par exemple, la sensibilité (on peut mesurer des puissances aussi faibles que -70 dBm, soit 0,1 nW), la dynamique (typiquement 50 dB), l'intégrabilité à des circuits planaires silicium et la rapidité (temps de réponse global de 1 μs environ). Cependant, ces capteurs sont non linéaires en puissance au-dessus de -20 dBm (soit 10 μW). Pour pouvoir mesurer des puissances supérieures, il faut placer un atténuateur dans la chaîne de mesure, mais cela dégrade la précision de la mesure. Dans ce cas, les constructeurs sont obligés de proposer des capteurs à diodes ayant un circuit électronique élaboré, comprenant un microprocesseur et des mémoires, afin de corriger ces non linéarités. Ceci augmente le prix de tels capteurs.

Dans les capteurs thermiques, deux types de mesure sont principalement utilisés : la mesure « compensée » et la mesure « directe » .

Dans le cas d'une mesure compensée, la charge absorbe la puissance électromagnétique, mais aussi celle fournie par un courant électrique continu supplémentaire, et est maintenue à température constante en régulant le niveau de la puissance absorbée (toute variation de la puissance électromagnétique est compensée par une variation en sens inverse de la puissance fournie par un courant électrique continu). La mesure du courant électrique continu donne le niveau de puissance électromagnétique de l'onde. La fabrication de ce type de capteur présente cependant l'inconvénient d'être technologiquement complexe.

Dans le cas d'une mesure directe, l'onde électromagnétique est absorbée dans une charge adaptée et convertie en chaleur (principe de la bolométrie); réchauffement de la structure est alors mesuré avec une thermistance ou un thermocouple. Ce type de capteur comporte deux éléments distincts : la charge adaptée, qui absorbe la puissance et la convertit en chaleur, et le thermomètre qui peut être une thermistance ou un thermocouple. Les avantages de tels capteurs thermiques sont la précision dans la mesure, la bande passante et le fait que les mesures à fortes puissances soient possibles.

Le document US 5 302 024 décrit aussi un capteur de puissance comprenant une charge dissipative, une ligne de transmission pour transmettre la puissance à la charge et une jonction de diode sensible à la chaleur, positionnée à proximité de la charge et dont la conductivité dépend de la chaleur dégagée par la charge.

Un but de l'invention est de fournir un capteur pour la mesure directe d'une puissance électromagnétique, donnant une mesure précise, ayant une bande passante relativement large et autorisant des mesures à forte puissance, ceci tout en ayant un faible coût de fabrication.

Ce but est atteint, selon l'invention, grâce à un capteur pour la mesure directe de la puissance électromagnétique, comprenant une structure guidante pour amener la puissance, une charge dissipative et un thermomètre, caractérisé par le fait qu'un élément unique forme la charge et le thermomètre.

En effet, un tel capteur est un capteur thermique. Il présente donc les avantages de ce type des capteurs tout en étant, par le fait que la charge et le thermomètre constituent un élément unique, d'une réalisation technologique simplifiée et par conséquent d'un coût de fabrication plus faible.

Avantageusement, la structure guidante est une structure planaire, notamment sous forme de ligne micro-ruban. Le capteur peut alors être intégré dans une structure elle même planaire.

Avantageusement encore, la transition entre la structure guidante et la charge est réalisée selon un profil en pointe. Cette transition peut être réialiséeavec une charge ayant un profil en pointe et/ou une structure guidante ayant un profil en pointe. Une telle technique est aussi appelée tapérisation, du verbe anglais « to taper », qui signifie " affiner, tailler en pointe". Cette technique permet d'avoir, en entrée de la charge, une impédance caractéristique proche de l'impédance nominale 50 Ohms de la ligne. La ligne tapérisée absorbe progressivement la puissance micro-onde incidente tout en minimisant alors les réflexions parasites. La puissance est dissipée sous forme de chaleur donc la température de la ligne augmente et, par conséquent, la résistance en courant continu de la ligne varie (sans que cela n'affecte le comportement hyperfréquence de la ligne). Il suffit donc de mesurer cette variation..

Le terme "charge" utilisé dans ce texte correspond à une charge localisée et/ou une charge répartie.

Selon un autre aspect, l'invention est un procédé de fabrication de capteurs pour la mesure directe de la puissance électromagnétique, comprenant la réalisation d'une structure guidante pour amener la puissance, d'une charge dissipative et d'un thermomètre, caractérisé par le fait que l'on réalise, la charge et le thermomètre.

Avantageusement alors, selon ce procédé, on réalise la transition entre la structure guidante et la charge selon un profil en pointe.

Selon un autre aspect, l'invention est un dispositif comprenant un capteur tel que celui présenté ci-dessus.
Avantageusement alors, celui-ci comprend deux éléments dont

- l'un est un capteur pour la mesure directe de la puissance électromagnétique, qui comprend une structure guidante pour amener la puissance, une charge dissipative et un thermomètre, ces deux derniers formant un élément unique, et
- l'autre sert à la régulation de la température du capteur pour la mesure directe de la puissance électromagnétique

Ceci permet de compenser les variations de la température ambiante. Selon une variante, le dispositif servant à la régulation de la température peut-être un dispositif à effet Peltier. Selon une autre variante du dispositif selon l'invention, celui-ci comprend deux éléments identiques audit capteur, mais seulement l'un d'entre eux est soumis à l'onde électromagnétique dont on veut mesurer la puissance.

On fait alors une mesure différentielle, dans laquelle tous deux sont placés dans un pont de Wheastone, et l'un est soumis à l'onde l'électromagnétique tandis que l'autre non. Ceci garantit une mesure de la puissance, reproductible quelle que soit la dérive en température du capteur.

D'autres aspects, buts et avantages de l'invention apparaîtront à la lecture de la description détaillée qui suit. L'invention sera aussi mieux comprise à l'aide des dessins annexés sur lesquels:

- la figure 1 représente schématiquement, en perspective, un premier mode de réalisation d'un capteur selon l'invention ;

- la figure 2 représente schématiquement, vu de dessus, la charge tapérisée d'un capteur du type de celui représenté sur la figure 1 et une modélisation , en tronçons, de cette charge ;
- la figure 3 représente schématiquement, en coupe transverse, un capteur du type de celui représenté sur les figures 1 et 2 ;
- la figure 4 correspond à quatre courbes représentant le taux d'ondes stationnaires obtenues par simulation numérique d'un capteur du type de celui représenté sur les figures 1, 2 et 3, en fonction de ses dimensions ;
- la figure 5 représente schématiquement, vue de dessus, la ligne micro-ruban d'un capteur du type de celui représenté sur les figures 1, 2 et 3 ;
- la figure 6 représente schématiquement, un dispositif de mesure comprenant un capteur du type de celui représenté sur les figures 1, 2, 3 et 4 ;
- la figure 7 représente schématiquement, vu de dessus, un deuxième mode de réalisation d'un capteur selon l'invention ;
- la figure 8 représente schématiquement, vu de dessus, une variante du capteur représenté sur la figure 7 ;
- la figure 9 est une représentation du taux d'ondes stationnaires mesurées sur un capteur du type de celui représenté sur les figures 7 et 8 ;
- la figure 10 représente schématiquement, un dispositif de mesure comprenant un capteur du type de celui représenté sur les figures 7, et 8 ;
- les figures 11a et 11b représentent une variante du capteur selon l'invention, correspondant à un mode de réalisation dit CPW ; la figure 11a correspond à une coupe transverse de ce capteur; la figure 11b correspond à une vue de dessus du capteur correspondant à la figure 11a ;
- la figure 12 représente, en vue de dessus, une variante du capteur selon l'invention, correspondant à une structure analogue à celle représentée sur les figures 11a et 11b, dans laquelle la tapérisation a été inversée transversalement ;
- la figure 13 représente, en coupe transverse, une variante du capteur selon l'invention, correspondant à une structure du type de celles représentées sur les figures 11 et 12, auxquelles un plan de masse a été rajouté en face arrière du substrat ;
- les figures 14a, 14b et 14c représentent une variante du capteur selon l'invention, correspondant à un mode de réalisation du type ligne coplanaire asymétrique ; les figures 14a et 14b correspondent à une coupe transverse de deux modes de réalisation distincts de capteurs correspondant à ce type de structure ; la figure 14c correspond à une vue de dessus du capteur correspondant au mode de réalisation illustré sur la figure 14b ; et
- les figures 15a et 15b représentent une variante du capteur selon l'invention, correspondant à un mode de réalisation du type à fente ; la figure 15a correspond à une coupe transverse ; la figure 15b correspond à une vue de dessus du capteur illustré à la figure 15a.

Dans un tel capteur, l'onde réfléchie doit non seulement être minime, mais de plus, elle doit être absorbée par le matériau sur son trajet de retour. Il doit s'agir d'une ligne à pertes. En outre, le coefficient de réflexion doit être stable en température et en fréquence, pour que toute la puissance injectée dans le capteur soit effectivement absorbée, et ce, sur une large bande. Le capteur selon l'invention est conçu pour satisfaire à ces conditions.

La géométrie du capteur est déterminée par l'impédance d'entrée du dispositif à une fréquence donnée, le coefficient de réflexion et le taux d'ondes stationnaires.

Deux modes de réalisation du capteur selon l'invention vont être décrits de manière détaillée ci-dessous.

Selon le premier mode de réalisation, le capteur est un capteur à charge tapérisée de nitrure de niobium (NbN).

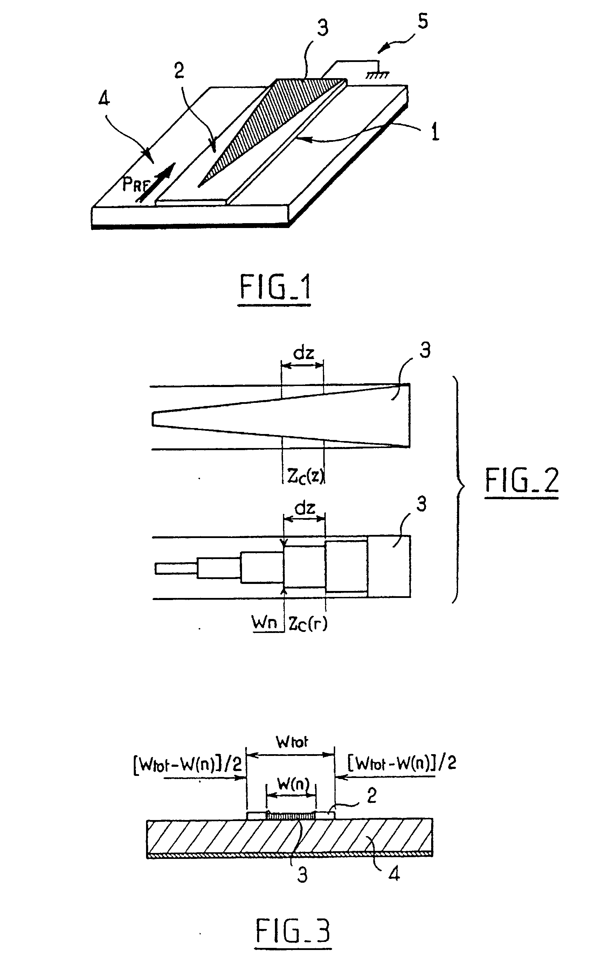

Ce premier mode de réalisation est représenté sur la figure 1. Selon ce mode de réalisation, le capteur 1 comprend une ligne 2 micro-ruban en platine et une charge tapérisée 3 en NbN, déposées sur un substrat 4 d'oxyde de magnésium (MgO) de 250 µm d'épaisseur (propriétés de l'oxyde de magnésium : permittivité diélectrique $\varepsilon_r$=9,6, facteur de perte tan$\delta$=$10^{-4}$, conductivité thermique $k_{th}$≈ 20 W.m$^{-1}$.k$^{-1}$). La ligne 2 de platine cède progressivement la place en son centre à une couche de NbN profilée en pointe. La transition entre la structure guidante et la charge est donc ici réalisée avec une charge 3 ayant un profil en pointe. En bout de ligne, un court-circuit 5. permet la connexion de la charge 3 à la masse électrique.

A l'opposé de la charge tapérisée 3 par rapport au court-circuit 5, est injectée la puissance électromagnétique $P_{RF}$.

Le NbN est très sensible vis à vis de la température, ce qui présente l'avantage que très peu de puissance suffit à provoquer une variation de résistance mesurable.

On peut modéliser la ligne tapérisée comme étant une association en série de n tronçons de lignes de longueur $dz$ et de largeur $W_n$ (figure 2).

La figure 3 est un schéma en coupe d'un tronçon de ligne du capteur tapérisé correspondant à ce premier mode de réalisation. Ce tronçon a une largeur totale $W_{tot}$. La largeur de NbN dans ce tronçon est $W(n)$.

Chaque tronçon est considéré du point de vue de la résistivité comme l'association en parallèle, d'un tronçon résistif en NbN et de deux tronçons en platine. Toutefois, le rapport des résistivités entre ces deux matériaux fait que la résistance équivalente est essentiellement dûe à la contribution du platine.

La largeur totale $W_{tot}$ peut être déterminée par simulation sur le logiciel SuperCompact™. Il s'agit de la largeur de la ligne 2 micro-ruban, au niveau de l'accès au capteur 1, constituée par le platine seul. Elle doit être telle que l'impédance caractéristique de cet accès soit 50 Ohms. Une telle simulation indique que la largeur totale $W_{tot}$ doit être égale à 250 µm.

Pour le tronçon n de longueur $dz$, d'impédance caractéristique $Z_c(n)$, de constante de propagation $\gamma(n)$ et chargé par une impédance $Z_T(n)$, l'impédance ramenée en entrée s'écrit :

$$Z_e(n) = Z_c(n)\cdot\frac{Z_T(n)+ Z_c(n)\cdot \tanh\,[\gamma(n).dz]}{Z_c(n)+ Z_T(n)\cdot \tanh\,[\gamma(n).dz]}$$

Tous les paramètres intervenant dans cette expression sont calculés à chaque nouvelle itération $n$, en fonction de la largeur $W(n)$.

Le quadripôle $n$=1 est le dernier tronçon de NbN: il est chargé par un court-circuit 5. Par conséquent, $Z_e(1) = Z_c(1)\cdot\tanh\,[\gamma(1).dz]$

Par suite, le quadripôle $n$=2 a pour impédance de charge $Z_T(2)$, l'impédance d'entrée $Z_e(1)$ du quadripôle $n$=1, d'où :

$$Z_e(2) = Z_c(2)\cdot\frac{Z_e(1)+ Z_c(2)\cdot \tanh\,[\gamma(2).dz]}{Z_c(2)+ Z_e(1)\cdot \tanh\,[\gamma(2).dz]}$$

Et ainsi de suite de proche en proche pour toute la longueur du capteur 1.

On peut alors calculer le taux d'ondes stationnaires, en fonction de la géométrie du capteur 1 (longueur du capteur 1 : / et largeur du premier tronçon de NbN : $W_{min}$).

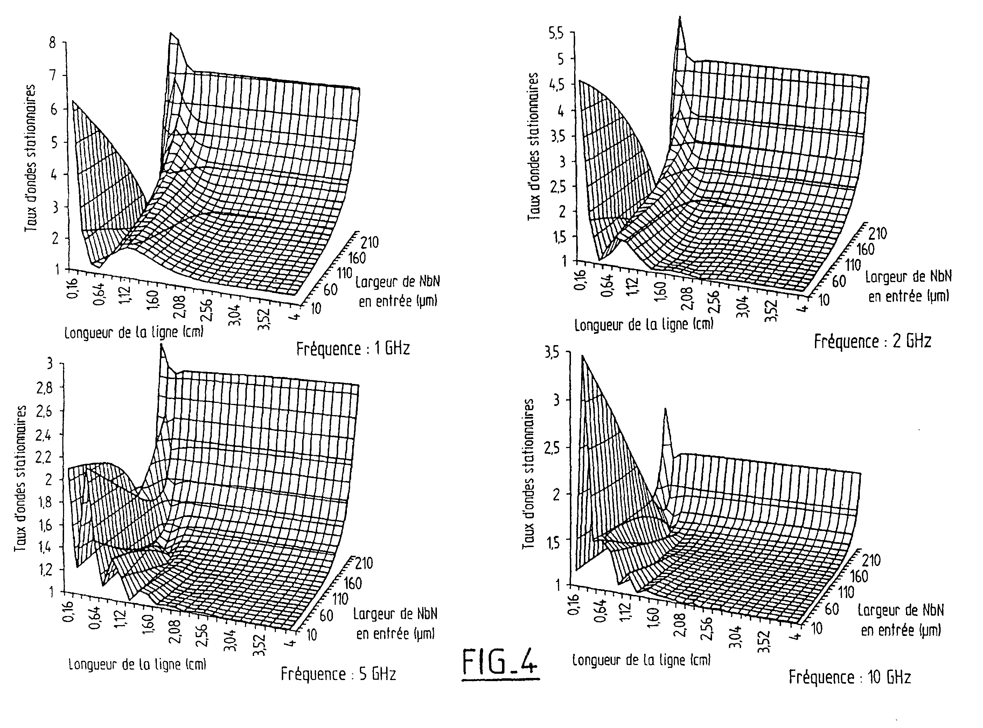

La figure 4 montre des courbes du taux d'ondes stationnaires en entrée du capteur 1, obtenues à différentes fréquences dans la gamme 1-10 GHz, et avec les paramètres :

    résisivité du NbN = 10mΩ.cm
    résisivité du platine = 10µΩ.cm
    épaisseur de métallisation =1000.10$^{-10}$m (1000Å).

Ces courbes montrent que la stabilité du taux d'ondes stationnaires est proche d'une valeur de 1, à partir d'une longueur de tapérisation supérieure à 2 cm environ. Communément, on accepte un taux d'ondes stationnaires inférieur à 1,1, même si dans l'industrie, des taux d'ondes stationnaires de 1,5 sont fréquents.

Ceci conduit à choisir les paramètres suivants pour la géométrie du capteur 1 : longueur de tapérisation $l$ = 23 mm (23 tronçons) et largeur du premier tronçon $W_{min}$=10µm.

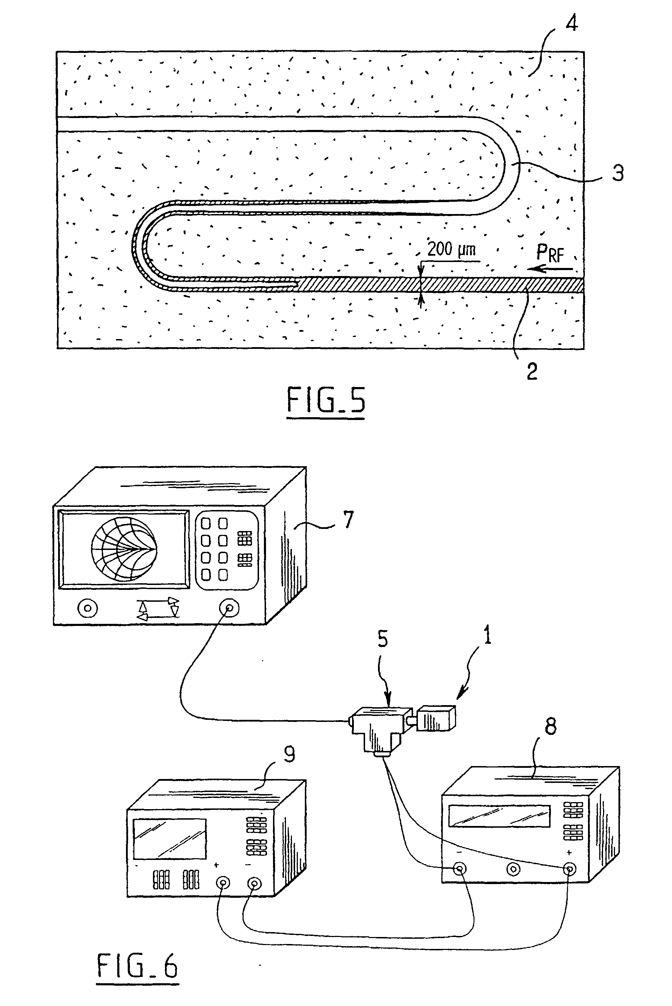

La ligne est formée en déposant, par pulvérisation cathodique, à 300°C, une couche de 1000.10$^{-10}$ m (1000Å) de platine, puis en réalisant un motif par photolithographie UV, suivie d'une gravure ionique. Ce motif est en forme de méandre (figure 5). Il est défini par un premier masque. Son complémentaire, défini par un deuxième masque, sert à réaliser la charge 3 de NbN.

Le motif en méandre permet de réduire l'encombrement tout en augmentant la sensibilité, grâce à une maximisation de la concentration de l'échauffement.

La charge 3 est réalisée par "lift-off" (la technique dite du "lift-off" est une procédure de réalisation de motifs de matériau en couches minces qui consiste à déposer la couche mince sur un substrat qui porte déjà une résine déterminant un motif, puis d'ôter la résine par dissolution dans un solvant, seules les zones qui n'avaient pas de résine subsistent alors). Elle fait $1200.10^{-10}$m (1200Å) d'épaisseur et recouvre le motif de platine sur 10μm, sur les bords de celui, afin d'assurer contact électrique.

Le substrat 4 est doré en face arrière pour constituer le plan de masse.

Le capteur 1 selon ce premier mode de réalisation a été caractérisé en réflexion avec un analyseur de réseau vectoriel Hewlett Packard™ 8720B, après un étalonnage OSL (de l'expression anglosaxonne "Open Short Load" qui signifie « circuit ouvert/court-circuit/ charge adaptée » et qui correspond à une procédure d'étalonnage standard en trois points) entre 160 MHz et 12 GHz. On peut alors constater que le taux d'ondes stationnaire est constant sur une large bande de fréquences.

Le capteur 1 selon ce premier mode de réalisation a aussi été caractérisé en réflexion. A cette fin, un courant continu a été injecté dans le capteur 1, à travers un té de polarisation 6 Rhode et Schwartz™, tandis que la réflexion était mesurée, avec une puissance RF faible, de manière à ne provoquer aucun échauffement supplémentaire. Ceci a permis de constater que l'injection d'un fort courant, chauffant le capteur 1, fait chuter la résistance tout en laissant inchangée la courbe donnant les variations du coefficient de réflexion en fonction de la fréquence.

On peut donc prévoir qu'un tel capteur 1 conserve un coefficient de réflexion constant, lorsque la dissipation de la puissance électromagnétique injectée provoque une variation de température.

Une mesure de puissance électromagnétique a été réalisée en utilisant le capteur 1 obtenu selon ce premier mode de réalisation.

La figure 6 montre le dispositif expérimental utilisé pour cette mesure. Ce dispositif expérimental comprend une source hyperfréquence correspondant à la source synthétique d'un analyseur de réseau vectoriel 7 Hewlett Packard™ 8753C. La mesure de la puissance électromagnétique est effectuée en déterminant la variation de la résistance $R_{cc}$ du capteur 1, grâce à l'injection d'un faible courant continu issu d'une source de courant continu 8 Time™ 609. La variation de résistance provoque une variation de tension lue sur un voltmètre numérique 9 Hewlett Packard™ 34401.

Le capteur 1, soumis à une puissance RF de 20 dBm (100 mWatts), à la fréquence de 3,5 GHz, donne une variation de la résistance de 100 Ω. La sensibilité de ce capteur 1 correspond donc à $1k\Omega.W^{-1}$, soit en grandeurs relatives,

$$\frac{\Delta R_{cc}}{R_{cc}} = 4,2\%.W^{-1}.$$

Selon le deuxième mode de réalisation du capteur, celui-ci est un capteur à ruban de platine tapérisé.

Pour des températures supérieures à 100 K, la résistivité du platine varie linéairement avec la température et le coefficient de variation de la résistivité

$$\alpha = \frac{1}{R}\frac{dR}{dT}$$

est environ égal à $+0,4\%.~K^{-1}$.

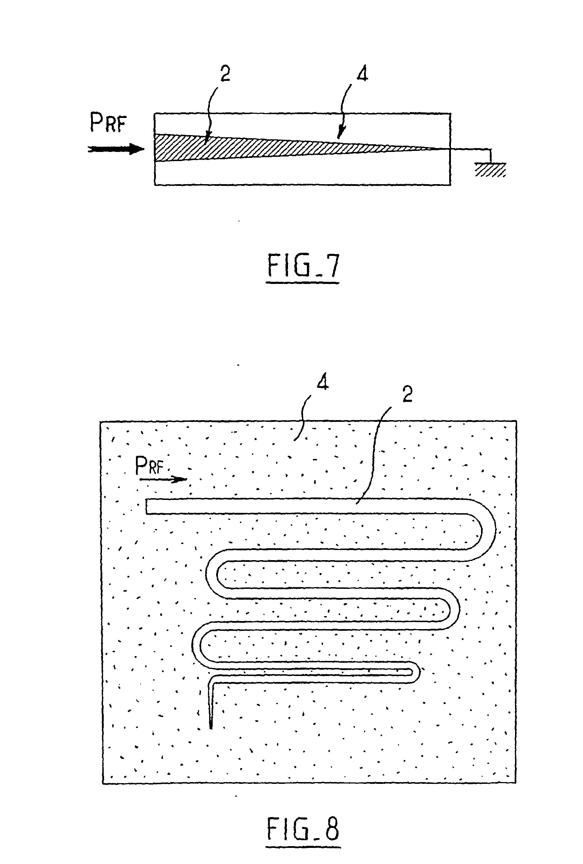

Selon ce deuxième mode de réalisation, le capteur 1 comprend une ligne micro-ruban 2 en couche mince de platine, tapérisée comme shématisé sur la figure 7 et déposée sur un substrat d'aluminate de lanthane $(LaAlO_3)$ de 500 μm d'épaisseur et de surface 5x5 $mm^2$ (la conduction thermique de la $LaAlO_3$ est $k_{th}$=12 $W.m^{-1}.K^{-1}$).

En bout de ligne, un court-circuit 5 permet la connexion du ruban 2 à la masse électrique.

Par rapport à MgO, $LaAlO_3$ présente une plus grande permittivité diélectrique ($\varepsilon_r$ = 24,2 à 300 K), ce qui permet de diminuer la vitesse de phase dans la structure et par conséquent aussi de diminuer la longueur d'onde guidée.

Les dimensions de la ligne, nécessaires pour avoir une impédance caractéristique égale à 50 Ω, a été évaluée par simulation sur le logiciel SuperCompact™, en considérant le ruban tapérisé comme une succession de plusieurs lignes micro-ruban résistives de différentes largeurs, terminée par un court-circuit 5 à la masse. Selon cette simulation, cette largeur doit être égale à 170 μm.

L'épaisseur de métallisation est $800.10^{-10}$m (800 Å).

La tapérisation est réalisée sur une longueur de 23 mm, la largeur variant de 170 μm, en début de ligne, à 20 μm, en fin de ligne, et possède un profil en méandre (figure 8), confiné dans une petite surface (environ 5x4 $mm^2$).

Avec cette géométrie, le couplage entre deux tronçons de ligne adjacents reste faible.

Selon ce mode de réalisation, la ligne 2 est formée en déposant par pulvérisation cathodique à 200° C, une couche de $800.10^{-10}$m(800Å) de platine sur le substrat. 4.

Une gravure ionique permet ensuite de ne garder que le méandre tapérisé.

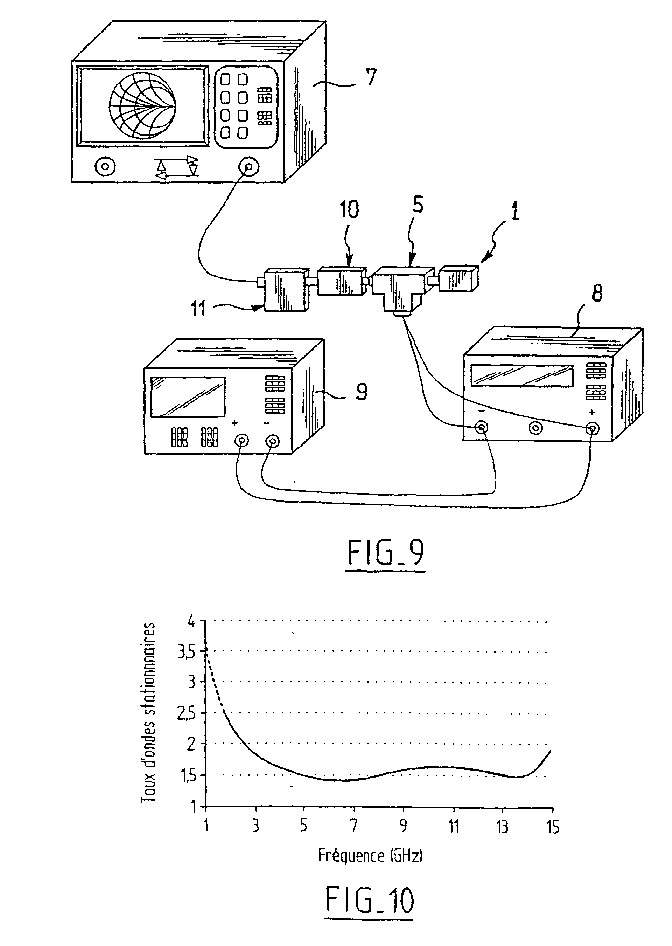

Le capteur 1 réalisé selon ce deuxième mode de réalisation a été caractérisé en réflexion avec un analyseur de réseau vectoriel Hewlett-Packard™ 8720B, après un étalonnage OSL, entre 160 MHz et 20 GHz. On peut alors constater que le taux d'ondes stationnaires est inférieur à 2 sur la gamme 2,5 GHz-15 GHz. Ce capteur 1 est donc bien adapté sur une large bande (figure 9).

L'extraction des paramètres du connecteur, réalisée grâce au logiciel SuperCompact™, a révélé que le taux d'ondes stationnaires pouvait être inférieur à 1,5 sur la gamme 4,5 GHz-12 GHz. 1,5 est une valeur typique de taux d'ondes stationnaires des wattmètres industriels.

En dessous de 2,5 GHz, l'utilisation de ce type de capteur 1 pour la mesure de puissance n'est pas possible, puisque son taux d'ondes stationnaires devient trop grand; ceci est bien entendu inhérent au principe même de la tapérisation.

Le taux d'ondes stationnaires du capteur 1 a été mesuré sur un l'analyseur de réseau vectoriel à la température ambiante, ainsi qu'à une température de 40°C. Sur la bande de fréquences 4-8 GHz, le taux d'ondes stationnaires reste insensible aux variations de température. Entre 8 et 12 GHz, les courbes des taux d'ondes stationnaires en fonction de la fréquence sont légèrement diffrentes. Au delà de 12 GHz cette différence devient plus importante. Mais, ce comportement peut provenir d'autres facteurs que ceux liés directement au capteur 1.

Une mesure de puissance électromagnétique a été réalisée en utilisant le capteur 1 obtenu selon le deuxième mode de réalisation décrit ci-dessus.

La figure 10 montre le dispositif expérimental utilisé pour cette mesure. Il comprend

un analyseur 7 (Hewlett Packard™ 8720B),

un amplificateur hyperfréquence 10 (Elexience™ CNA02082840, gamme de fréquences : 2-8 GHz, gain : 28 dB min, point de compression à 1 dB : 18 dB min, taux d'ondes stationnaires : 2),

un isolateur 11 commercialisé par MTC™ (isolation 18 dB, pertes d'insertion 0,5 dB, ROS 1,35 (ROS signifie « Rapport d'Ondes Stationnaires »), puissance moyenne supportée 25 Watts),

une source de courant continu 8 Time™ 609 et

un voltmètre numérique 9 Prema™ 5017

L'analyseur 7 délivre une puissance hyperfréquence de -10 dBm. Celle-ci est ensuite amplifiée grâce à l'amplificateur hyperfréquence 10

L'isolateur 11 protège l'analyseur 7 contre un retour de forte puissance. Un isolateur MTC™ de type F105 a été utilisé pour les mesures dans la gamme 2-4 GHz. Un isolateur MTC™ de type H105 a été utilisé pour les mesures dans la gamme 4-8 GHz.

Le capteur 1 est monté sur un porte-échantillon en cuivre. L'onde électromagnétique est amenée par un câble coaxial. La connexion entre le capteur 1 et le câble coaxial est assurée par un connecteur SMA. Le support du substrat 4 est muni, sous le plan de masse du capteur 1, d'un trou de 4 mm de diamètre, percé dans le cuivre de façon à diminuer les échanges thermiques et ainsi augmenter l'échauffement de la ligne 2 tapérisée si celle-ci absorbe une puissance micro-onde. Il faut noter que ce choix technique dégrade le temps de réponse du capteur 1; cela importe peu si l'on ne souhaite pas construire un capteur rapide mais un capteur qui mesure la puissance d'une onde en régime entretenu ou permanent.

Le capteur 1 a été soumis à un échelon de puissance de -30 dBm à +20 dBm, et la variation de sa résistance en courant continu a été mesurée sur le voltmètre numérique 9 grâce à l'injection d'un faible courant de 100 µA, issu de la source de courant continu 8. Ces mesures ont été réalisées à la fréquence de 6,7 GHz, où le taux d'ondes stationnaires est minimal et vaut 1,4.

Avant de le soumettre à un échelon de puissance hyperfréquence, on laisse au système de mesure le temps d'atteindre une température stable. En effet, en fonctionnement, l'amplificateur 10 chauffe et atteint une température de 54°C, quelle que soit la puissance micro-onde en entrée.

La mesure de la puissance est donnée par la valeur de la résistance lorsque le capteur a atteint son régime permanent : la sensibilité du capteur a été évaluée ici à 10 $\Omega$, pour 100 mW, soit 100 $\Omega.W^{-1}$.

Le capteur 1 réalisé selon le deuxième mode de réalisation décrit ci-dessus, permet donc de mesurer la puissance d'une onde électromagnétique guidée dans une structure planaire, avec une sensibilité de 100 $\Omega.W^{-1}$ et dans une gamme de fréquences typique de 2 à 12 GHz.

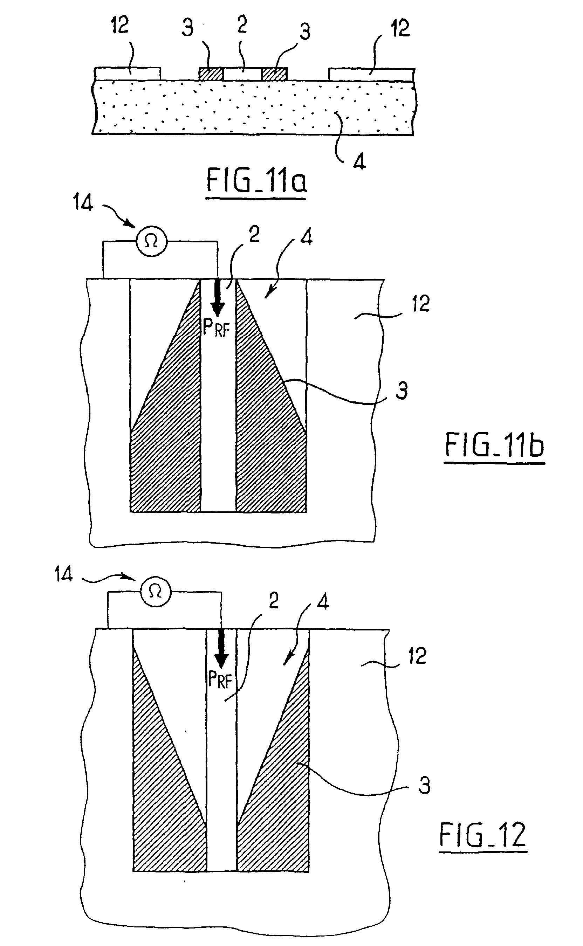

Deux modes de réalisation du capteur selon l'invention ont été décrits de manières détaillée ci-dessus, mais il existe de nombreuses autres modes de réalisation conformes à l'invention qui est limitée par les revendications. Quelques uns d'entre eux sont brièvement décrits ci-dessous en relation avec les figures 11 à 15.

Les figures 11a et 11b représentent un capteur correspondant à un mode de réalisation dit CPW (de l'expression anglo-saxonne « Coplanar Wave Guide », qui correspond à un type de structures bien connu de l'Homme du Métier). Le capteur 1 comprend une ligne 2, une charge 3 tapérisée et une couche métallique 12 de masse. La mesure de la puissance électromagnétique est alors réalisée grâce à un dispositif 14 mesurant la résistance avec un courant continu. La résistance étant mesurée entre la ligne 2 et la couche métallique 12 de masse. La figure 11a correspond à une coupe transverse du capteur 1 correspondant à ce mode de réalisation. La figure 11b correspond à une vue de dessus du capteur 1 correspondant à la figure 11a.

La figure 12 correspond à une structure analogue à celle représentée sur les figures 11a et 11b, dans laquelle la tapérisation a été inversée transversalement.

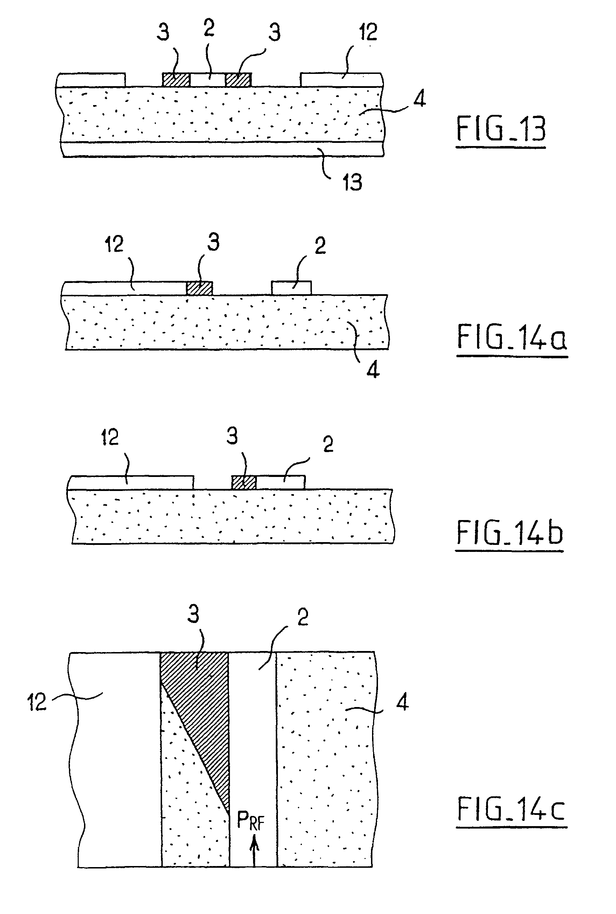

La figure 13 correspond à une structure du type de celles représentées sur les figures 11 et 12, auxquelles un plan de masse 13 a été rajouté en face arrière du substrat 4. Ce type de structure correspond à un mode de réalisation appelé GCPW (de l'expression anglo-saxonne « Grounded Coplanar Waveguide »).

Les figures 14a, 14b et 14c correspondent à un mode de réalisation du type ligne coplanaire asymétrique. Les figures 14a et 14b correspondent à une coupe transverse du capteur 1 correspondant à deux modes de réalisation distincts de capteurs 1 correspondant à ce type de structure. La figure 14c correspond à une vue de dessus du capteur 1 correspondant au mode de réalisation du capteur 1 représenté sur la figure 14b. On peut également concevoir, à l'image de la structure représentée sur la figure 13, des capteurs 1 tels que ceux des figures 14 a, 14b et 14c, avec un plan de masse 13 à l'arrière du substrat 4.

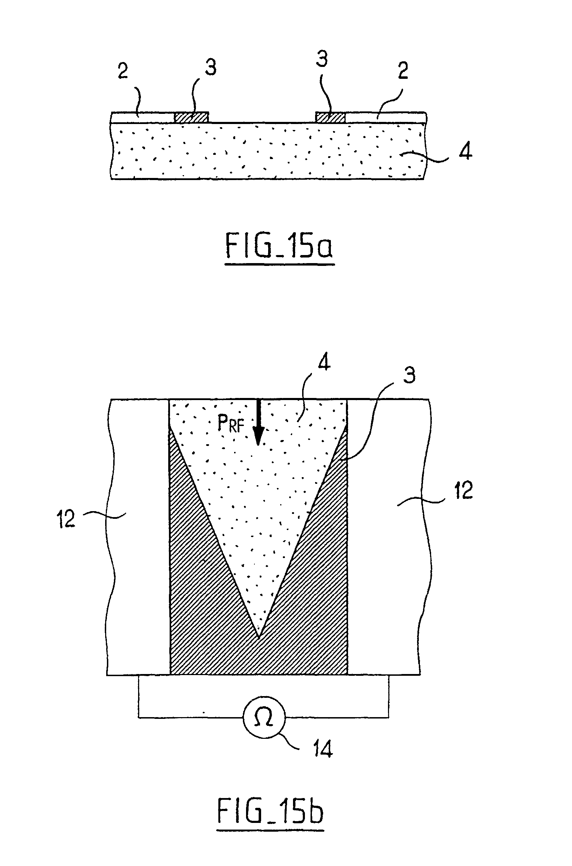

Les figures 15a et 15b correspondent à un mode de réalisation du type à fente. La figure 15a correspond à une coupe transverse du capteur 1 correspondant à ce mode de réalisation. La figure 15b correspond à une vue de dessus du capteur 1 correspondant à la figure 15a. La charge 3 est tapérisée. L'onde électromagnétique est guidée dans la fente par le substrat 4 et atténuée progressivement dans la charge 3, qui longe les plans de masse 12 latéraux. La mesure de la résistance est réalisée entre les deux les plans de masse 12 latéraux. On peut également concevoir, à l'image de la structure représentée sur la figure 13, des capteurs 1 tels que celui des figures 15a et 15b, avec un plan de masse 13 à l'arrière du substrat 4.

D'une manière générale, un capteur 1 selon l'invention pourra être réalisé sous forme de n'importe quelle structure de type planaire, en particulier, permettant d'effectuer un remplissage partiel d'un matériau dissipatif, afin de créer une charge, répartie, tapérisée, à pointe saillante ou rentrante, accessible par une mesure en courant continu. On peut également envisager de tapériser la structure guidante elle même, c'est à dire les métallisations. De faible coût, car plus simple technologiquement que les capteurs existants sur le marché actuellement, ce capteur 1 ne fait appel qu'à un seul élément métallique déposé sur un substrat 4 diélectrique de permittivité relativement élevée. Il est intégrable dans la plupart des circuits hyperfréquences, et bénéficie, d'un taux d'ondes stationnaires très compétitif vis à vis des capteurs industriels traditionnels.

Afin d'améliorer les performances de ce type de capteur 1 on peut réguler la température du support (en cuivre) du capteur avec un système miniature à effet Peltier.

La compensation des variations de température ambiante peut aussi se faire, en réalisant sur le même substrat deux capteurs identiques. Placés tous deux dans un pont de Wheatstone, l'un est soumis à l'onde électromagnétique, l'autre non, selon le principe du capteur différentiel. La linéarité intrinsèque de la sensibilité thermique du platine garantit alors une mesure de puissance reproductible quelle que soit la dérive en température du capteur 1.

L'invention permet donc la mesure de la valeur efficace vraie de la puissance d'une onde électromagnétique guidée sur un circuit planaire, dans une gamme de puissance de typiquement 1 mW à 1 W (voire plus si l'on adjoint au capteur un coupleur de puissance) et dans une gamme de fréquences typique de 2 GHz à 15 GHz. Suivant les cas, cette mesure est effectuée pour :

- contrôler que le niveau de puissance en sortie d'un composant ou d'un système est correct et répond à un cahier des charges ou à une norme (en conception, en production et en maintenance sur site ou à distance).
- mesurer un niveau de puissance à des fins d'étalonnage de systèmes hyperfréquences.

Les domaines d'application sont nombreux car les systèmes hyperfréquences sont très répandus et correspondent aux domaines d'application des wattmètres industriels hyperfréquences :

- en télécommunications et en télédiffusion (par exemple dans le contrôle in situ du niveau à la sortie d'un oscillateur local, d'une source ou dans une boucle à verrouillage de phase) ;
- en instrumentation scientifique hyperfréquence ;
- en instrumention radar militaire, embarquée ou non ;
- en agro-alimentaire. (séchage, cuisson et décongélation) ou dans la fabrication de matières premières (pâte à papier, caoutchouc...) avec l'adjonction d'un coupleur de puissance.

L'invention présente les avantages suivants :

a- faible coût car plus simple technologiquement que les capteurs existant sur le marché actuellement ;
b- versatilité à la technologie de substrat employée dans le système hyperfréquence où prend place le capteur (il est cependant plus spécifiquement dédié aux systèmes ayant une constante diélectrique suffisamment grande afin de garder un capteur de dimensions raisonnables) ;
c- intégrabilité ;
d- linéarité intrinsèque (ce n'est pas le cas de capteurs existants) ;
e- sensibilité nulle aux variations de température ambiante ;
f- bande passante ;
g- faible ROS ;
h- mesure directe de la valeur efficace vraie de la puissance (comme tout capteur thermique).

## Revendications

1. Capteur pour la mesure directe de la puissance électromagnétique, comprenant une structure guidante (2) pour amener la puissance, une charge (3) dissipative et un thermomètre, **caractérisé par le fait qu'**un élément unique forme la charge (3) et le thermomètre.

2. Capteur selon la revendication 1, **caractérisé par le fait que** la structure guidante (2) est une ligne planaire, notamment micro-ruban.

3. Capteur selon l'une des revendications précédentes, **caractérisé par le fait que** la transition entre la structure guidante (2) et la charge (3) est réalisée avec une charge (3) ayant un profil en pointe.

4. Capteur selon l'une des revendications 1 ou 2, **caractérisé par le fait que** la transition (2) entre la structure guidante (2) et la charge (3) est réalisée avec une structure guidante (2) ayant un profil en pointe.

5. Procédé de fabrication de capteurs pour la mesure directe de la puissance électromagnétique, comprenant la réalisation d'une structure guidante (2) pour amener la puissance, d'une charge (3) dissipative et d'un thermomètre, **caractérisé par le fait que** l'on réalise un élément résistif unique constituant la charge (3) et le thermomètre.

6. Procédé selon la revendication 5, **caractérisé par le fait que** l'on réalise la transition entre la structure guidante (2) et la charge (3) selon un profil en pointe.

7. Dispositif de mesure de la puissance électromagnétique comprenant un capteur (1) selon l'une des revendications 1 à 4.

8. Dispositif selon la revendication 7 **caractérisé par le fait qu'**il comprend deux éléments dont

   - l'un est ledit capteur (1), et

   - l'autre sert à la régulation de la température du capteur (1) pour la mesure directe de la puissance électromagnétique.

9. Dispositif selon la revendication 8 **caractérisé par le fait que** l'élément qui sert à la régulation de la température du capteur (1 )est un dispositif à effet Peltier.

10. Dispositif selon la revendication 7 **caractérisé par le fait qu'**il comprend deux éléments identiques au capteur (1), mais que seulement l'un d'entre eux est soumis à l'onde électromagnétique dont on veut mesurer la puissance.

## Patentansprüche

1. Sensor zur direkten Messung der elektromagnetischen Leistung, der eine Führungsstruktur (2) zum Zuführen der Leistung, eine dissipative Last (3) und einen Thermometer aufweist, **dadurch gekennzeichnet, dass** ein einzelnes Element die Last (3) und das Thermometer bildet.

2. Sensor nach Anspruch 1, **dadurch gekennzeichnet, dass** die Führungsstuktur (2) eine planare Leitung ist, insbesondere ein Mikro-Streifen.

3. Sensor nach einem der vorhergehenden Ansprüche, **dadurch gekennzeichnet, dass** der Übergang zwischen der Führungsstruktur (2) und der Last (3) mit einer Last (3) verwirklicht ist, die ein Punktprofil hat.

4. Sensor nach einem der Ansprüche 1 oder 2, **dadurch gekennzeichnet, dass** der Übergang (2) zwischen der Führungsstruktur (2) und der Last (3) mit einer Führungsstruktur (2) realisiert ist, die ein Punktprofil hat.

5. Verfahren zu Herstellung von Sensoren für die direkte Messung der elektromagnetischen Leistung, das die Herstellung einer Führungsstruktur (2) zum Zuführen der Leistung, einer dissipativen Last (3) und eines Thermometers umfaßt, **dadurch gekennzeichnet, dass** ein einzelnes Widerstandselement hergestellt wird, das die Last (3) und das Thermometer bildet

6. Verfahren nach Anspruch 5 **dadurch gekennzeichnet, dass** der Übergang zwischen der Führungsstruktur (2) und der Last (3) gemäß einem Punktprofil hergestellt wird.

7. Vorrichtung zum Messen der elektromagnetischen Leistung, die einen Sensor (1) nach einem der Ansprüche 1 bis 4 aufweist.

8. Vorrichtung nach Anspruch 7, **dadurch gekennzeichnet, dass** sie zwei Elemente aufweist, von denen

   - das eine der Sensor (1) ist, und
   - das andere zum Regeln der Temperatur des Sensors (1) für die direkte Messung der elektromagnetischen Leistung dient.

9. Vorrichtung nach Anspruch 8, **dadurch gekennzeichnet, dass** das Element, das zum Regeln der Temperatur des Sensors (1) dient, eine Einrichtung nach dem Peltier-Effekt ist.

10. Vorrichtung nach Anspruch 7, **dadurch gekennzeichnet, dass** sie zwei mit dem Sensor (1) identische Elemente aufweist, von denen jedoch nur eines der elektromagnetischen Welle ausgesetzt wird, deren Leistung gemessen werden soll.

**Claims**

1. Sensor for the direct measurement of electromagnetic power, comprising a guiding structure (2) for injecting the power, a dissipative load (3) and a thermometer, **characterized in that** a single element forms the load (3) and the thermometer.

2. Sensor according to Claim 1, **characterized in that** the guiding structure (2) is a planar line, especially a microstrip.

3. Sensor according to either of the preceding claims, **characterized in that** the transition between the guiding structure (2) and the load (3) is made with a load (3) having a pointed profile.

4. Sensor according to either of Claims 1 and 2, **characterized in that** the transition between the guiding structure (2) and the load (3) is made with a guiding structure (2) having a pointed profile.

5. Process for manufacturing sensors for the direct measurement of electromagnetic power, comprising the production of a guiding structure (2) for injecting the power, of a dissipative load (3) and of a thermometer, **characterized in that** a single resistive element constituting the load (3) and the thermometer is produced.

6. Process according to Claim 5, **characterized in that** the transition between the guiding structure (2) and the load (3) is made with a pointed profile.

7. Device for measuring electromagnetic power, comprising a sensor (1) according to one of Claims 1 to 4.

8. Device according to Claim 7, **characterized in that** it comprises two elements, of which:

   - one is the said sensor (1); and
   - the other serves for regulating the temperature of the sensor (1) for the direct measurement of electromagnetic power.

9. Device according to Claim 8, **characterized in that** the element which serves for regulating the temperature of the sensor (1) is a Peltier-effect device.

10. Device according to Claim 7, **characterized in that** it comprises two elements identical to the sensor (1), but that only one of them is exposed to the electromagnetic wave whose power it is wished to measure.

FIG_1

FIG_2

FIG_3

FIG_4

$$P_{RF}$$

FIG.5

FIG.6

FIG.7

FIG.8

FIG_9

Fréquence (GHz)

FIG_10

FIG_11a

FIG_11b

FIG_12

FIG.13

FIG.14a

FIG.14b

FIG.14c

FIG_15a

FIG_15b